(19) Europäisches Patentamt
European Patent Office
Office européen des brevets

(11) **EP 2 494 564 B1**

(12) **FASCICULE DE BREVET EUROPEEN**

(45) Date de publication et mention de la délivrance du brevet:
**21.01.2015 Bulletin 2015/04**

(21) Numéro de dépôt: **10763350.5**

(22) Date de dépôt: **28.09.2010**

(51) Int Cl.:
***H01H 1/00*** *(2006.01)*    ***G01R 31/333*** *(2006.01)*

(86) Numéro de dépôt international:
**PCT/EP2010/064370**

(87) Numéro de publication internationale:
**WO 2011/051067 (05.05.2011 Gazette 2011/18)**

(54) **SYSTEME DE DIAGNOSTIQUE PREVENTIF DE L'IMPEDANCE DE CONTACT ET DES SURCHARGES D'UN COMMUTATEUR**

SYSTEM ZUR PRÄVENTIVEN DIAGNOSE EINES KONTAKTSCHEINWIDERSTANDS UND VON ÜBERLASTUNGEN EINES UMSCHALTERS

SYSTEM FOR PREVENTIVE DIAGNOSIS OF CONTACT IMPEDANCE AND OVERLOADS OF A COMMUTATOR

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **28.10.2009 EP 09174389**

(43) Date de publication de la demande:
**05.09.2012 Bulletin 2012/36**

(73) Titulaire: **Delphi Technologies, Inc.**
**Troy, MI 48007 (US)**

(72) Inventeur: **KEBIR, Abdelmoneim**
**F-93350 Le Bourget (FR)**

(74) Mandataire: **Robert, Vincent et al**
**Delphi France SAS**
**Bât. le Raspail - ZAC Paris Nord 2**
**22, avenue des Nations**
**CS 65059 Villepinte**
**95972 Roissy CDG Cedex (FR)**

(56) Documents cités:
**EP-A1- 0 193 732    EP-A2- 1 462 768**

**Description**

DOMAINE TECHNIQUE

La présente invention concerne de manière générale un système de diagnostique utilisé dans le cadre de la protection électrique et contre les départs d'incendie provoqués par une dérive fonctionnelle de tout ou partie d'un équipement faisant intervenir une énergie électrique, thermique, magnétique ou chimique. Plus particulièrement, la présente invention concerne un système de diagnostique pour surveiller et prévenir des dérives de caractéristiques physiques de composants de type mécanique (sectionneur...) ou électromécaniques (relais, contacteur...) commutant des circuits électriques non protégés en courant (ex. fusible, détection thermique ...), et ceci notamment dans le cadre d'application à l'automobile.

ARRIERE-PLAN TECHNOLOGIQUE

Dans un circuit électrique, les deux principaux événements redoutés sont d'une part la dégradation des performances électriques avec perte de contrôle de la position d'un contact et la dégradation des performances de ce contact et d'autre part la dégradation des performances thermiques avec détection des cas de surcharges électriques plus ou moins importantes.
Tout d'abord pour bien comprendre les risques encourus, il est important de poser le diagnostique fonctionnel pour un commutateur de puissance, i.e. un élément de commutation, et son circuit de charge. La surveillance de la dérive des caractéristiques d'un élément de commutation peut être faite soit de façon électrique ou soit de façon thermique. Dans tous les cas, les caractéristiques électriques et thermiques ont une interaction selon l'origine de la défaillance. Les cas de figure les plus fréquents sont listés ci-après.

- Cas n°1 : Une surcharge apparaît aux bornes de l'élément de commutation, entraînant une surchauffe de l'élément puis une dégradation des caractéristiques électriques / mécaniques conduisant à un départ de feu ;
- Cas n°2 : Une dégradation des caractéristiques électriques / mécaniques de l'élément de commutation entraîne une surchauffe conduisant à un départ de feu ;
- Cas n°3 : Une dégradation des caractéristiques électriques / mécaniques de l'élément de commutation entraîne une surchauffe conduisant à une perte de la fonction de commutation ;
- Cas n°4 : Une dégradation des caractéristiques électriques / mécaniques entraîne directement une perte de la fonction de commutation.

D'après les différents cas de figures ci-dessus, on observe que la perte de fonction brutale (Cas n°4) est particulière et ne suit pas le même mécanisme que les autres. En effet la composante thermique n'apparaît pas forcément. Cet aspect a été considéré dans le cadre de la présente invention pour maximiser les performances de diagnostique en termes de taux de couverture. Les autres cas de figure considérés (Cas n°1, 2 et 3) ont des liens de cause à effet. Dans tous ces cas, la présence d'une surchauffe est probable et constitue un état intermédiaire. En tout état de cause, quelque soit le cas de figure, la dégradation de performances ou l'éminence d'un dysfonctionnement passe par la dégradation de certains paramètres de construction de l'élément de commutation, tels que l'impédance de contact, la tenue mécanique de l'élément, une perte d'étanchéité ou une rupture d'isolation, etc.
En outre, une dégradation d'un élément de commutation peut être due à n'importe quel élément le constituant, de sorte que dans tous les cas de figure, les dérives se répercutent sur les caractéristiques électriques et thermiques. Ces dérives peuvent être dues par exemple à une mauvaise utilisation, un défaut de fabrication, une atteinte des limites spécifiées, un dépassement de la durée de vie d'un l'élément, un nombre de cycle, etc.
Ainsi, dans la plupart des cas de figure, la détection de la dégradation d'une ou plusieurs caractéristiques n'est possible actuellement que par un diagnostique de type curatif (mesures, contrôles...) et non systématique et en temps réel. C'est pourquoi, un diagnostique permettant de prévenir l'indisponibilité ou la destruction d'un élément de commutation de puissance (ex : relais...) s'avèrerait très utile et présenterait une réelle valeur ajoutée. Néanmoins, une solution qui consisterait à effectuer une mesure du courant circulant dans la charge de l'élément de commutation en introduisant un shunt en série de la charge n'est pas envisageable en raison du grand nombre d'inconvénients que cela présente. En effet, le seul avantage réside dans la mesure de courant qui se trouve facilité, dans la mesure où le courant se déduit de la tension aux bornes du shunt. En revanche, l'utilisation d'un shunt introduit un élément résistif dont la valeur de résistance devra être très faible pour des courants forts, tandis que la puissance dissipée par le shunt impose des limitations en termes de volume et de prix. En outre, une grande stabilité thermique est nécessaire pour obtenir des mesures avec une bonne précision. On notera que l'ajout d'un tel élément résistif introduit des contraintes de câblage impactant la précision de la mesure. On notera encore que cela nécessite une électronique de traitement sophistiquée d'instrumentation en particulier pour les courants forts, surtout en position flottante.

Le document "EP 1 462 768 A2" décrit un circuit de mesure selon le préambule de la revendication 1.

RESUME DE L'INVENTION

Un but de la présente invention est de répondre aux inconvénients mentionnés ci-dessus en fournissant un circuit de mesure d'une grandeur électrique caractéristique d'un élément de commutation permettant de surveiller en permanence l'état général de l'élément de commutation et éventuellement suivre son évolution dans le temps.

Dans ce but, un premier aspect de la présente invention concerne un circuit de mesure d'une grandeur électrique aux bornes d'un élément de commutation ayant une première borne à un potentiel amont et une deuxième borne à un potentiel aval, caractérisé en ce que le circuit de mesure comprend un dispositif de traitement différentiel des potentiels amont et aval alimenté par un dispositif d'alimentation fonctionnant uniquement lors de la fermeture de l'élément de commutation, un dispositif de protection du potentiel amont entre ladite première borne et une première entrée du dispositif de traitement différentiel commandé par un dispositif de commutation du potentiel amont assurant l'alimentation de ladite première entrée uniquement lorsque l'élément de commutation est fermé et un dispositif de protection aval entre ladite deuxième borne et une deuxième entrée du dispositif de traitement différentiel commandé directement par la fermeture de l'élément de commutation assurant l'alimentation de ladite deuxième entrée. Avantageusement, la grandeur électrique mesurée est l'impédance de contact de l'élément de commutation obtenue par l'intermédiaire de la différence de potentiel entre les potentiels amont et aval. Un tel circuit de mesure permet de surveiller l'impédance de contact en utilisant l'élément de commutation comme shunt lors de sa fermeture. La protection des potentiels amont et aval permet prévenir tout disfonctionnement interne au circuit de mesure lorsque l'élément de commutation est ouvert.

Selon un mode de réalisation avantageux, le dispositif de protection du potentiel amont comprend des moyens de protection de la première entrée du dispositif de traitement différentiel (BF4) contre l'inversion de polarités due à la commutation de l'élément de commutation. Il comprend de préférence deux transistors montés tête-bêche imposant un sens unidirectionnel de polarisation. En outre, il peut être prévu deux résistances dimensionnées pour polariser les deux transistors simultanément.

Selon un autre mode de réalisation avantageux, le dispositif de commutation du potentiel amont comprend un transistor commutant les deux transistors lorsque l'élément de commutation est commandé en fermeture. Il comprend en outre, de préférence, un circuit de polarisation dimensionné pour polariser le dispositif de protection du potentiel amont dans toute la gamme de fonctionnement de la batterie d'alimentation de l'ensemble.

Selon un autre mode de réalisation avantageux, le circuit de protection du potentiel aval est choisi identique au circuit de protection du potentiel amont.

Selon un autre mode de réalisation avantageux, le dispositif de traitement différentiel comprend un amplificateur opérationnel en montage soustracteur. Avantageusement, le montage soustracteur comprend des résistances périphériques choisies de sorte que le rapport des résistances connectées à la première entrée de l'amplificateur opérationnel est égal au rapport des résistances connectées à la deuxième entrée (E-) de l'amplificateur opérationnel.

Selon un autre mode de réalisation avantageux, les transistors du dispositif de protection du potentiel amont sont choisis avec des faibles valeurs de résistance interne par rapport à la résistance de la première du montage soustracteur.

Selon un autre mode de réalisation avantageux, le dispositif d'alimentation comprend une diode protégeant le dispositif de traitement différentiel contre les inversions de polarités.

L'objectif final est de prévenir les disfonctionnements de type intempestifs, dérives dans le temps de l'élément de commutation ou perte de fonction brutale et éviter les conditions d'échauffements aggravés dues à l'élément surveillé avec éventuellement départ de feu.

Dans ce but, un deuxième aspect de la présente invention concerne un système de diagnostique fonctionnel d'un élément de commutation comprenant un circuit de mesure selon le premier aspect, caractérisé en ce qu'il comprend en outre une unité de traitement pour surveiller des dérives de la grandeur électrique mesurée.

BREVE DESCRIPTION DES FIGURES

D'autres caractéristiques et avantages de la présente invention apparaîtront plus clairement à la lecture de la description détaillée qui suit de modes de réalisation de l'invention donnés à titre d'exemples nullement limitatifs et illustrés par les dessins annexés, dans lesquels :

- la figure 1 représente un schéma bloc d'un système de diagnostique selon un mode de réalisation de l'invention ;
- la figure 2 représente un schéma des blocs fonctionnels d'un circuit de mesure selon un mode de réalisation de l'invention ;
- la figure 3 représente un schéma électronique d'un circuit de mesure selon un mode de réalisation de l'invention ;
- la figure 4 représente une séquence de fonctionnement d'un système de diagnostique selon un mode de réalisation de l'invention ;
- la figure 5 représente un diagramme des phases de vie de l'élément de commutation.

DESCRIPTION DETAILLEE DE L'INVENTION

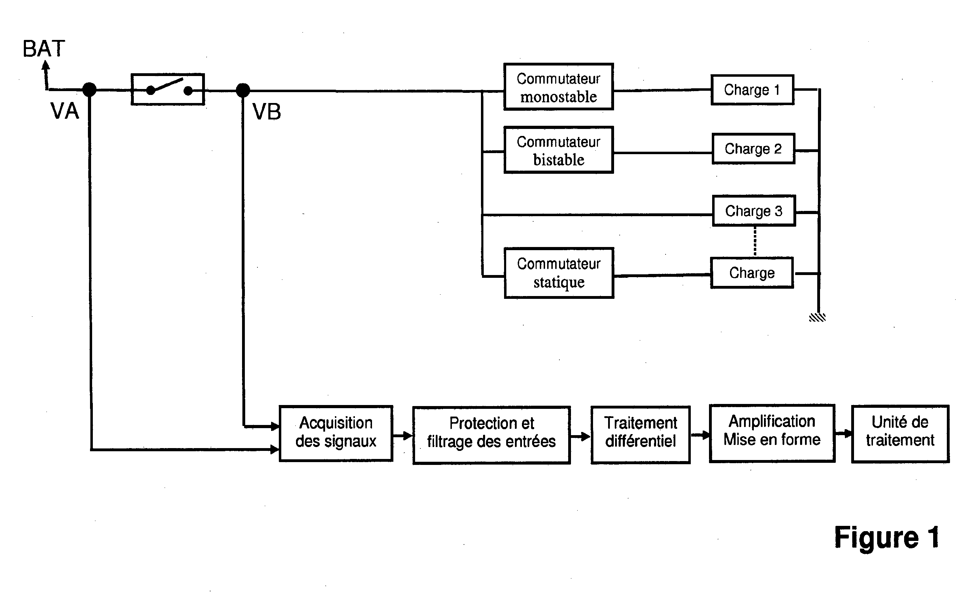

L'invention sera décrite ci-après uniquement à titre d'exemples non limitatifs en relation avec les figures 1 à 5. Néanmoins, tout d'abord avant de rentrer dans le détail de ces figures, il est important d'identifier le problème lié aux éléments de commutation. Le dernier maillon d'une chaîne de défaillance sur un élément de commutation est l'élément qui réalise la fonction de commutation.

On s'intéressera donc au contact de puissance, qui est accessible facilement et qui est l'une des plus importantes sources de chaleur produite par l'élément de commutation. Les caractéristiques accessibles sont donc la différence de potentiel aux bornes du contact, i.e. de l'élément de commutation dans sa position fermée, le courant dans le contact, la température du commutateur, le temps de réponse, le positionnement mécanique et l'impédance de contact. Ainsi, par exemple, la prise en compte des aspects électriques et thermiques sur un élément de commutation de type relais électromécanique consiste à connaître l'énergie qui y transite. En effet, lorsque l'énergie mise en oeuvre ou emmagasinée dépasse les limites spécifiées par le constructeur, les dérives et dégradations peuvent apparaître à courts termes.

La puissance active dans le cas d'un commutateur est l'image de son comportement thermique. Ainsi la surveillance de la tension de contact passe par la connaissance du niveau d'énergie dans le commutateur.

$$\text{P\_commutateur = P\_absorbée – P\_transmise} \qquad (1)$$

$$\text{= U\_alimentation x I\_charge – U\_charge x I\_charge} \qquad (2)$$

$$\text{= I\_charge x (U\_alimentation – U\_charge)} \qquad (3)$$

$$\text{= I\_charge x Chute de tension dans le commutateur} \qquad (4)$$

$$\text{= I\_charge x I\_charge x Impédance du contact} \qquad (5)$$

$$\text{W\_commutateur = I\_charge x I\_charge x Impédance du contact x temps} \qquad (6)$$

avec W l'énergie en joules, R la résistance de contact (ohm), t le temps en seconde et I_charge le courant en ampère.

Ainsi donc par la mesure des grandeurs électriques de contact du commutateur, il est possible de connaître le comportement électrique et thermique d'un commutateur en surveillant l'énergie qu'il accumule lorsqu'il est parcouru par le courant qu'il fait passer pendant une durée donnée.

La mesure de la chute de tension permet de connaître l'impédance d'un élément parcouru par un courant connu, ou de connaître le courant connaissant l'impédance de l'élément. La chute de tension renseigne donc sur le niveau de surcharge pour un contact d'impédance normal ou la dégradation du contact pour un courant normal. Dans les deux cas, la situation est source de surchauffe de l'élément de commutation et sujet à destruction nécessitant de préférence une intervention préventive.

A cet effet, dans le cadre de la présente invention, il est prévu d'effectuer, d'une part, la mesure de courant important (charge et surcharge) en s'affranchissant des méthodes conventionnelles de mesure, telles que tension aux bornes d'un shunt ou tout autre moyen coûteux et inadapté. Pour cela, on utilisera une méthode volt ampérométrique sans utiliser de shunt de mesure mais l'impédance du contact. D'autre part, il est prévu avantageusement de surveiller simultanément des dérives de l'impédance de contact traversé par un courant de charge normal et connu / prévisible. On pourra utiliser le même principe à savoir une méthode volt ampérométrique aux bornes du contact à surveiller.

L'idée de réaliser ces deux mesures (impédance de contact et surcharge) simultanément présente deux difficultés. La première difficulté consiste à devoir extraire d'un circuit de mesure une valeur fiable et précise d'une impédance de contact très faible en s'affranchissant de nombreuses problématiques techniques comme le recours aux composants dédiés ou coûteux, ou à une mise en oeuvre complexe, ceci en ayant le souci de rester compatible avec des contraintes de l'automobile (par ex. tension, température, inversion de polarité, caractère bistable ou non du commutateur, etc.). La seconde difficulté consiste à mesurer correctement un courant sans impacter significativement le coût de la solution de base.

L'utilisation de systèmes différentiels avec amplificateur opérationnel s'avère bien adapter aux mesures dites conventionnelles utilisant des shunts. Dans le cas présent, l'avantage est d'utiliser directement le contact de l'élément de commutation pour faire office de shunt. Toutefois, le contact de l'élément de commutation présente l'inconvénient d'avoir deux niveaux d'impédances suivant qu'il est ouvert ou fermé. Cet aspect impose des limitations en ce qui concerne le système différentiel à utiliser.

Considérons maintenant la figure 1 représentant un système de diagnostique sous forme de schéma bloc. Le système de diagnostique fonctionnel d'un élément de commutation CC comprend un dispositif d'acquisition des signaux en amont et en aval de l'élément de commutation, en vue de la mesure d'une grandeur électrique aux bornes de l'élément, suivi d'un dispositif de filtrage et de protection des entrées d'un dispositif de traitement différentiel effectuant ladite mesure. Ensuite, il peut être prévu un dispositif d'amplification, généralement interne au dispositif de traitement, et un dispositif de mise en forme et de filtrage du signal de sortie. Enfin, en bout de chaîne est prévue une unité de traitement du signal de sortie pour prévenir tout disfonctionnement découlant des mesures effectuées.

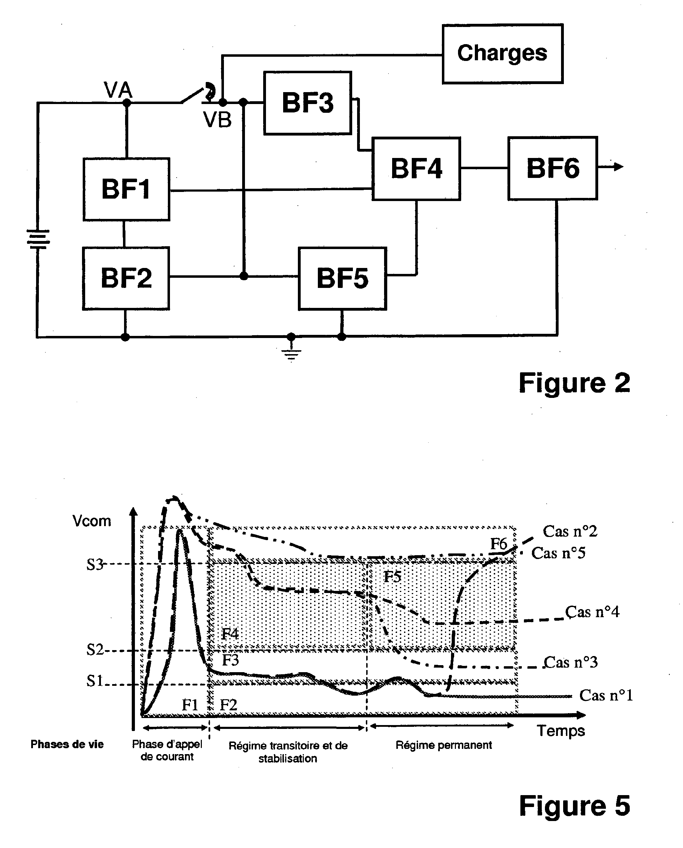

La figure 2 représente un schéma des blocs fonctionnels d'un circuit de mesure appliqué à un élément de commutation. Sur cette figure, on retrouve l'élément de commutation CC alimenté par une batterie pouvant être par exemple celle du véhicule automobile dans lequel l'élément est intégré. L'élément de commutation présente deux bornes amont et aval ayant respectivement un potentiel amont VA et un potentiel aval VB. Entre les deux bornes de l'élément de commutation CC est prévu un dispositif de traitement différentiel BF4 des potentiels amont et aval alimenté par un dispositif d'alimentation BF5 fonctionnant uniquement lors de la fermeture de l'élément de commutation et protégeant de fait le dispositif BF4. Pour protéger les deux entrées du dispositif BF4, il est également prévu un dispositif de protection BF1 du potentiel amont entre la borne amont et l'entrée correspondante du dispositif de traitement différentiel et un dispositif de protection BF3 aval entre la borne aval et l'autre entrée du dispositif de traitement différentiel. Le dispositif de protection du potentiel amont BF1 est commandé par un dispositif de commutation BF2 du potentiel amont assurant l'alimentation de l'entrée correspondante du dispositif BF4 uniquement lorsque l'élément de commutation est fermé. De l'autre côté, le dispositif de protection BF3 du potentiel aval est directement commandé par la fermeture de l'élément de commutation CC assurant l'alimentation de l'autre entrée du dispositif BF4. En sortie du dispositif de traitement différentiel BF4, il peut être prévu un dispositif de mise en forme du signal de sortie BF6 qui est ensuite fourni à une unité de traitement (non représenté ici).

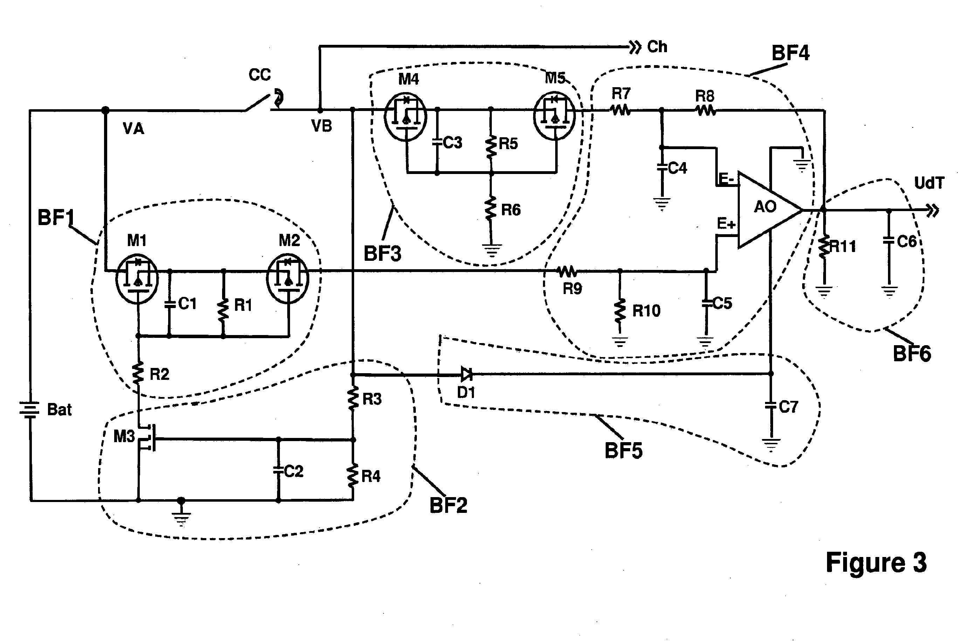

La figure 3 représente un schéma électronique d'un circuit de mesure selon la figure 2. Le principe global de fonctionnement de ce circuit ayant été décrit ci-dessus, nous allons maintenant regarder plus en détail un exemple de réalisation avantageux de chaque bloc fonctionnel.

BF1 : Dispositif de protection du potentiel amont

Le dispositif BF1 est constitué de deux transistors M1 et M2 montés têtes bêches. Ce montage est tel que les diodes intrinsèques des transistors permettent de protéger l'entrée E+ de l'amplificateur opérationnel du dispositif BF4, contre l'inversion de polarités tout en permettant au circuit d'être commutable avec une chute de tension en ligne négligeable. On notera que les transistors représentés ici sont des transistors MOSFET canal P à faible courant. Un schéma symétrique avec des transistors canal N est bien entendu possible.

Ainsi la commutation du circuit d'amplification en amont permet de protéger le circuit de mesure contre le maintien de l'entrée E+ alimentée alors que l'amplificateur opérationnel ne l'est pas. Un tel cas de figure est applicable quelque soit la nature de l'élément de commutation (bistable, monostable, statique...).

De plus, les deux transistors montés têtes bêches permettent d'imposer un sens unidirectionnelle de la polarisation. Cette polarisation n'est possible que lorsque le circuit amplificateur est alimenté par le biais du commutateur lui-même via les dispositifs BF2 et BF5. La commutation n'est donc possible que si l'élément de commutation est fermé. Les résistances R1 et R2 polarisent les deux transistors simultanément. Ces résistances R1 et R2 sont choisies de telle sorte que le circuit est commutable dans toute la gamme de tension de fonctionnement de la batterie.

Cette structure du dispositif BF1 permet de protéger le dispositif de traitement différentiel BF4 quelque soit la nature de l'élément de commutation, à savoir un commutateur bistable en mode normal, en inversion de polarité avec le contact en position ouverte ou fermée, en charges aval commutées (haute impédance), en charges aval non commutées (faible impédance), ou encore un commutateur monostable ou statique commandé de façon indépendante du commutateur central.

BF2 : Dispositif de commutation du potentiel amont

Le dispositif BF2 est constitué d'un transistor M3 (MOSFET canal N à faible courant) et d'un circuit de polarisation R3, R4, C2. Ce transistor M3 permet de commuter le dispositif de protection BF1 lorsque l'élément de commutation (ou commutateur central) est commandé en fermeture. De cette manière, l'entrée E+ est donc alimentée uniquement lorsque le commutateur central est fermé.

Le circuit de polarisation R3, R4, C2 est dimensionné pour assurer la polarisation de BF1 dans toute la gamme de tension de fonctionnement de la batterie. On choisira des valeurs importantes pour les résistances de polarisation de sorte que cette fonction soit aussi sécurisée contre les inversions de polarité.

BF3 : Dispositif de protection du potentiel aval :

La fonction du dispositif de protection BF3 est identique à celle du dispositif BF1, mais appliquée à l'entrée E-, dite aval. La différence réside dans le fait que la commutation du dispositif de protection BF3 n'est pas réalisée par le dispositif de commutation BF2, mais directement par le commutateur central lui-même.

Les transistors M4 et M5 sont polarisés de la même façon que pour le dispositif BF1 avec de préférence les mêmes valeurs et une même gamme de fonctionnement.

BF4 : Dispositif de traitement différentiel des potentiels amont et aval

Ce dispositif réalise un montage dit soustracteur comprenant un amplificateur opérationnel et permet d'amplifier la différence des potentiels amont et aval. L'amplification de la différence de potentiel aux bornes du commutateur central parcouru par un courant, renseigne sur l'impédance de contact du commutateur central, et/ou sur la présence d'une surcharge importante.

Les résistances périphériques sont choisies de telle sorte que le rapport R8/R7 soit identique à au rapport R10/R9 afin de minimiser les effets d'imperfection de la structure, comme par exemple le gain de mode commun. Dans le même esprit, les tolérances des résistances seront choisies de type faible (tolérance 1%) pour minimiser les dérives dues à la température et au vieillissement des composants. Pour cela, on choisira d'utiliser soit des résistances à faible coefficient de variation à la température TCR (ppm/°C) soit un réseau de résistances par 4 ou 8 offrant l'avantage de dériver de façon identique et de maintenir une dérive modérée du gain R8/R7 et R10/R9 quelques soient les conditions (température, vieillissement, etc....). L'utilisation de réseau de résistances offre aussi la possibilité si nécessaire de travailler avec une tolérance totale de l'ordre de 0.16%. En outre, on choisira de préférence les transistors M1 et M2 avec de faibles valeurs de résistance interne par rapport à R9.

Les condensateurs C4 et C5 assurent le filtrage des signaux d'entrées, permettant une bonne stabilité du signal de sortie, en particulier en cas d'évènements intempestifs, comme les commutations du commutateur central, de rebonds et d'autres phénomènes transitoires.

On notera que la structure de ce dispositif de traitement différentiel n'utilise pas d'amplificateur opérationnel spécialement dédié à la mesure de courant «high side» dite flottante, lui conférant un coût avantageux.

BF5 : Dispositif d'alimentation et protection de l'amplificateur opérationnel

Le dispositif BF5 est constitué de préférence de deux composants seulement. La diode D1 protège l'alimentation de l'amplificateur opérationnel contre les inversions de polarités. A cet effet, on choisira cette diode de sorte que la chute de tension provoquée reste modérée (Vf<0.6V).

Le condensateur C7 permet de filtrer l'alimentation de l'amplificateur opérationnel. Le condensateur est un condensateur de filtrage sécurisé afin de s'affranchir des problèmes de casse physique entraînant des courts-circuits francs ou impédants, source de dysfonctionnements ou d'échauffement aggravés. Pour cela, il est placé au plus près de l'alimentation de l'amplificateur opérationnel.

BF6 : Dispositif de mise en forme du signal de sortie

Le dispositif BF6 est également constitué de deux composants seulement. La résistance R11 polarise la sortie de l'amplificateur opérationnel tandis que le filtrage est assuré par le condensateur C6. Cette structure peut être enrichie pour améliorer sa protection selon la nature de l'entrée de l'unité de traitement qui suit, en utilisant par exemple une diode de clamp.

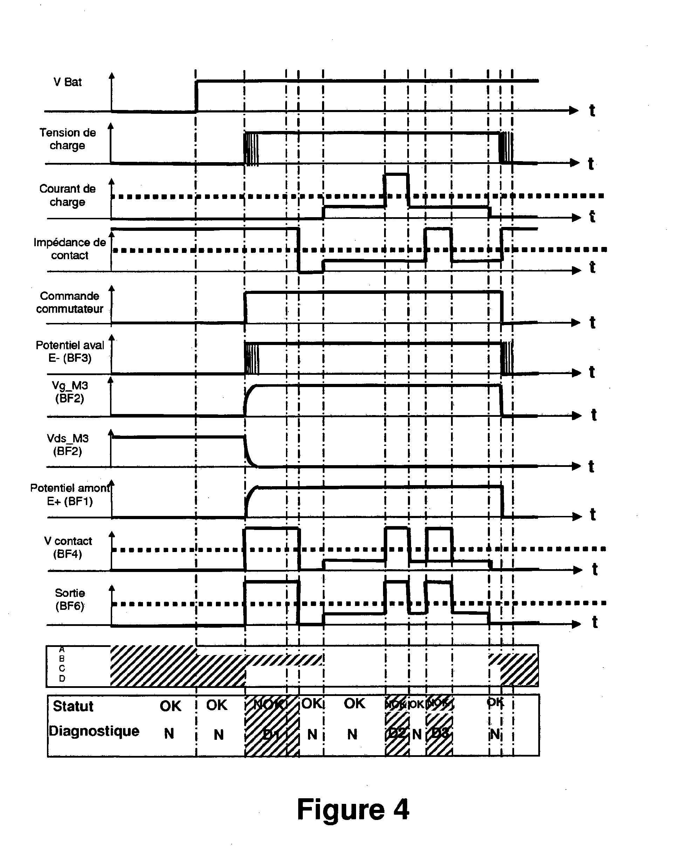

La figure 4 représente une séquence de fonctionnement du système de diagnostique. La première fonction représente la tension de la batterie d'alimentation du circuit de mesure. La deuxième fonction représente la tension de charge aux bornes de l'élément de commutation. La troisième fonction représente le courant de charge traversant l'élément de commutation. Une comparaison avec un seuil de courant prédéfini permet de détecter toute surcharge. La quatrième fonction représente l'impédance de contact de l'élément de commutation. Une comparaison avec un seuil d'impédance prédéfini permet de détecter un défaut d'impédance. La cinquième fonction représente la commande du commutateur. Le niveau haut représente une commande de fermeture du commutateur. On constate qu'elle est synchronisée avec la tension mesurée aux bornes du commutateur. La sixième fonction représente le potentiel aval à l'entrée E- en sortie du dispositif BF3. On constate que le potentiel aval correspond au signal de commande du commutateur, l'entrée E- étant alimentée directement par le commutateur lors de sa fermeture. La septième fonction représente la tension de grille du transistor M3 du dispositif BF2. La huitième fonction représente la tension drain-source du transistor M3 du dispositif BF2. La neuvième fonction représente le potentiel amont à l'entrée E+ en sortie du dispositif BF1. On constate qu'il correspond au signal de tension de grille du transistor M3 qui commande le dispositif de protection du potentiel amont. La dixième fonction représente la tension de contact mesurée par le dispositif BF4. La tension de contact permet de relever les surcharges et dérives d'impédance lors d'une commande de fermeture du commutateur, le dispositif BF4 n'étant pas alimenté en dehors d'une telle commande. La détection de tels disfonctionnements se fait par comparaison avec un seuil de tension prédéfini. La onzième fonction représente la sortie amplifiée du dispositif BF6 pour son traitement par l'unité de traitement.

En dessous des différentes fonctions sont représentées deux tableaux détaillant le traitement effectué par l'unité de traitement. La zone A indique lorsque le circuit de mesure n'est pas alimenté (hachures) et lorsqu'il est alimenté (absence de hachures) par la batterie. La zone B indique les périodes sans charge (hachures) et les périodes de charge (absence de hachures). La zone C indique la période de commande de fermeture du commutateur (absence de hachures). La zone D indique la période d'alimentation du dispositif de traitement différentiel (absence de hachures) qui correspond exactement à celle de la commande de fermeture de la zone C. Le deuxième tableau dessous représente le diagnostique posé par le système en fonction des mesures effectuées. Tout d'abord le statut général du commutateur est indiqué. A chaque fois, qu'une fonction dépasse le seuil prédéfini avec lequel la fonction est comparée, une indication de statut défectueux est généré (NOK), autrement le statut indique OK. En outre, l'unité de traitement permet de définir quel type de disfonctionnement est intervenu lorsque le statut est défectueux (NOK). Ainsi par exemple, dans le premier cas intervenant le long de l'axe des temps, le disfonctionnement est lié à un commutateur cassé en circuit ouvert dans la mesure où l'impédance de contact et la tension de contact sont toutes deux supérieures aux seuils prédéfinis. Dans le deuxième cas, le disfonctionnement du commutateur est lié à une surcharge détectée par l'intermédiaire du courant de charge dépassant le seuil de courant prédéfini. Enfin, dans le troisième cas, le disfonctionnement est lié à un défaut d'impédance dans la mesure où seule l'impédance de contact dépasse la valeur de seuil prédéfini.

La figure 5 représente un diagramme des phases de vie de l'élément de commutation. Ce diagramme décrit les valeurs de tension aux bornes du commutateur central durant ses différentes phases de vie. La zone F1 représente la zone de fonctionnement normal lors de phase d'appel de courant. La zone F2 représente la zone de fonctionnement normal lors du régime transitoire et de stabilisation de la tension de contact, qui doit être inférieure à un premier seuil S1 prédéfini. La zone F3 représente une zone de fonctionnement dégradé lors du régime transitoire et de stabilisation de la tension de contact, lorsqu'elle est supérieure à S1 et inférieure à un deuxième seuil S2 prédéfini. La zone F4 représente une zone de fonctionnement dégradé lors du régime transitoire et de stabilisation de la tension de contact, lorsqu'elle est supérieure à S2 et inférieure à un troisième seuil S3 prédéfini. La zone F5 représente une zone de fonctionnement dégradé lors du régime permanent de la tension de contact, lorsqu'elle est supérieure à S2 et inférieure à un troisième seuil S3 prédéfini. La zone F6 représente une zone de fonctionnement après la phase d'appel de courant, lorsque la tension de contact est supérieure à S3.

Le cas n°1 représente une phase de vie normale, avec un appel de courant au démarrage (Zone F1) puis une stabilisation du courant de charge en régime établi. L'impédance du contact est normale, on n'observe pas de surcharge importante (Zone F2).

Le cas n°2 représente une phase de vie normale au démarrage (Zone F1), avec un appel de courant au démarrage puis une stabilisation du courant de charge en régime établi. Là encore, l'impédance du contact est normale et on n'observe pas de surcharge importante (Zone F2). Toutefois, dans ce deuxième on observe une apparition d'un dysfonctionnement due à une surcharge (court-circuit franc ou impédant) en régime établi (Zones F3, F5 et F6).

Le cas n°3 représente une phase de vie avec un fort appel de courant, qui ne parvient pas à stabilisation vers des niveaux de tension de contact normaux. D'où la présence possible d'une surcharge ou la dégradation de l'impédance de contact du commutateur (Zones F4 en régime transitoire et F3 en régime permanent). Cette défaillance est considérée comme modérée, car ne présentant pas un cas d'échauffement aggravé avec risque d'incendie. Dans ce cas, l'unité de traitement peut faire une demande de délestage des fonctions dites non sécuritaires afin de réduire l'échauffement du commutateur et signaler la présence d'un dysfonctionnement en vue de procéder au remplacement du commutateur défectueux.

Le cas n°4 représente une phase de vie avec un fort appel de courant, qui ne parvient pas à stabilisation vers des niveaux de tension de contact normaux. D'où la présence possible d'une surcharge ou la dégradation de l'impédance de contact du commutateur (Zones F4 en régime transitoire et F5 en régime permanent). Cette défaillance est considérée comme importante car présentant un cas d'échauffement aggravé avec risque d'incendie. Dans ce cas, l'unité de traitement peut faire une demande de délestage des fonctions dites non sécuritaires afin de réduire l'échauffement du commutateur, suivie d'une demande d'arrêt d'urgence si le délestage n'améliore pas la situation.

Le cas n°5 présente une phase de vie où est présente un dysfonctionnement du commutateur avec perte de contact (Zone F6) due soit à une défaillance de la commande soit au blocage du contact en position ouverte, fermée ou intermédiaire. La phase de vie peut être normale avec un appel de courant au démarrage puis une stabilisation du courant de charge en régime établi (impédance du contact normale, pas de surcharge importante). Ce cas de figure peut donc être considéré comme normal dans le cas où aucune charge n'est sollicitée ou que le commutateur central est ouvert. D'où l'intérêt d'une unité de traitement qui connaisse la phase de vie dans laquelle le commutateur se trouve ainsi que les charges actives.

La description détaillée ci-dessus permet de montrer en particulier que la structure de traitement différentiel et notamment le montage amplificateur soustracteur permet de réaliser le diagnostique d'un commutateur moyennant l'ajout d'un certain nombre de composants de commande et de protection tout en assurant une consommation nulle lorsque le commutateur est ouvert, et faible en fonctionnement. En particulier, le principe de mesure de la tension de contact sans utiliser de shunt ou d'autres éléments que le commutateur lui-même est atypique par son caractère complètement passif et sécurisé. Cette solution peut être complétée par une unité de traitement logiciel pour surveiller le comportement, la dérive de l'impédance de contact et les surcharges dans les phases de vies du commutateur.

On comprendra que diverses modifications et / ou améliorations évidentes pour l'homme du métier peuvent être apportées aux différentes modes de réalisation de l'invention décrits dans la présente description sans sortir du cadre de l'invention défini par les revendications annexées.

En particulier, on notera qu'un diagnostique préventif doit passer par la mesure de paramètres électriques et/ou thermiques de l'élément de commutation. Bien que les deux approches soient possibles et complémentaires, il est préférable de les mettre en oeuvre simultanément pour des raisons de réduction des coûts, de réactivité, d'importance de la surcharge, de flexibilité de la solution, etc.

On notera encore que dans le cas d'une application à un commutateur bistable, qui est le cas le plus défavorable, le positionnement du contact ouvert/fermé implique des précautions de protection concernant l'alimentation principale du système différentiel, l'alimentation des entrées du système différentiel, l'inversion de polarité contact ouvert, l'inversion de polarité contact fermé, la nature commutée ou non de la charge, l'impédance de la charge pour le cas où elle n'est pas commutée, les contraintes de consommation en mode repos ainsi que des considérations de l'environnement automobile. Toutes ces implications ont été respectées dans la solution proposée ici. Néanmoins, dans les cas de commutateur monostable ou statique, la solution reste parfaitement applicable et peut même être allégée.

## Revendications

1. Circuit de mesure d'une grandeur électrique aux bornes d'un élément de commutation (CC) ayant une première borne à un potentiel amont (VA) et une deuxième borne à un potentiel aval (VB), le circuit de mesure comprenant un dispositif de traitement différentiel (BF4) des potentiels amont et aval alimenté par un dispositif d'alimentation (BF5) **caractérisé en ce que** le dispositif d'alimentation fonctionne uniquement lors de la fermeture de l'élément de commutation, un dispositif de protection (BF1) du potentiel amont entre ladite première borne et une première entrée du dispositif de traitement différentiel commandé par un dispositif de commutation (BF2) du potentiel amont assurant l'alimentation de ladite première entrée uniquement lorsque l'élément de commutation est fermé et un dispositif de protection (BF3) aval entre ladite deuxième borne et une deuxième entrée du dispositif de traitement différentiel commandé directement par la fermeture de l'élément de commutation assurant l'alimentation de ladite deuxième entrée.

2. Circuit de mesure selon la revendication 1, **caractérisé en ce que** la grandeur électrique mesurée est l'impédance de contact de l'élément de commutation (CC) obtenue par l'intermédiaire de la différence de potentiel entre les potentiels amont et aval.

3. Circuit de mesure selon la revendication 1 ou 2, **caractérisé en ce que** l'élément de commutation lors de sa fermeture fait office de shunt utilisé pour la mesure de la grandeur électrique.

4. Circuit de mesure selon l'une des revendications 1 à 3, **caractérisé en ce que** l'élément de commutation est un commutateur bistable.

5. Circuit de mesure selon l'une des revendications 1 à 4, **caractérisé en ce que** le dispositif de protection du potentiel amont (BF1) comprend des moyens de protection de la première entrée du dispositif de traitement différentiel (BF4) contre l'inversion de polarités due à la commutation de l'élément de commutation.

6. Circuit de mesure selon la revendication 5, **caractérisé en ce que** le dispositif de protection du potentiel amont (BF1) comprend deux transistors (M1, M2) montés tête-bêche imposant un sens unidirectionnel de polarisation.

7. Circuit de mesure selon la revendication 6, **caractérisé en ce que** le dispositif de protection du potentiel amont (BF1) comprend en outre deux résistances (R1, R2) polarisant les deux transistors (M1, M2) simultanément.

8. Circuit de mesure selon la revendication 6 ou 7, **caractérisé en ce que** le dispositif de commutation (BF2) du potentiel amont comprend un transistor (M3) commutant les deux transistors (M1, M2), lorsque l'élément de commutation est commandée en fermeture.

9. Circuit de mesure selon la revendication 8, **caractérisé en ce que** le dispositif de commutation (BF2) du potentiel amont comprend en outre un circuit de polarisation dimensionné pour polariser le dispositif de protection (BF1) du potentiel amont dans toute la gamme de fonctionnement d'une batterie.

10. Circuit de mesure selon l'une des revendications 1 à 9, **caractérisé en ce que** le circuit de protection (BF3) du potentiel aval est choisi identique au circuit de protection (BF1) du potentiel amont.

11. Circuit de mesure selon l'une des revendications précédentes, **caractérisé en ce que** le dispositif de traitement différentiel (BF4) comprend un amplificateur opérationnel (AO) en montage soustracteur.

12. Circuit de mesure selon la revendication 11, **caractérisé en ce que** le montage soustracteur comprend des résistances périphériques choisies de sorte que le rapport des résistances (R9/R10) connectées à la première entrée (E+) de l'amplificateur opérationnel est égal au rapport des résistances (R7/R8) connectées à la deuxième entrée (E-) de l'amplificateur opérationnel.

13. Circuit de mesure selon les revendications 5 et 12, **caractérisé en ce que** les transistors (M1, M2) sont choisis avec des faibles valeurs de résistance interne par rapport à la résistance (R9) d'entrée (E+) du montage soustracteur.

14. Circuit de mesure selon l'une des revendications précédentes, **caractérisé en ce que** dispositif d'alimentation (BF5) comprend une diode protégeant le dispositif de traitement différentiel (BF4) contre les inversions de polarités.

15. Système de diagnostique fonctionnel d'un élément de commutation comprenant un circuit de mesure selon l'une quelconque des revendications précédentes, **caractérisé en ce qu'**il comprend en outre une unité de traitement (UdT) pour surveiller des dérives de la grandeur électrique mesurée.

**Patentansprüche**

1. Messschaltung zum Messen einer elektrischen Größe an den Anschlussklemmen eines Schaltelements (CC), das eine erste Anschlussklemme mit einem stromaufwärtigen Potential (VA) und eine zweite Anschlussklemme mit einem stromabwärtigen Potential (VB) aufweist, wobei die Messschaltung eine Vorrichtung zur differentiellen Verarbeitung (BF4) des stromaufwärtigen und des stromabwärtigen Potentials aufweist, die über eine Versorgungsvorrichtung (BF5) gespeist wird, **dadurch gekennzeichnet, dass** die Versorgungsvorrichtung nur beim Schließen des Schaltelements betrieben wird, wobei eine Schutzvorrichtung (BF1) für das stromaufwärtige Potential zwischen der ersten Anschlussklemme und einem ersten Eingang der Vorrichtung zur differentiellen Verarbeitung, die über eine Schaltvorrichtung (BF2) für das stromaufwärtige Potential gesteuert wird, die Versorgung des ersten Eingangs nur dann sicherstellt, wenn das Schaltelement geschlossen ist, und wobei eine stromabwärtige Schutzvorrichtung (BF3) zwischen der zweiten Anschlussklemme und einem zweiten Eingang der Vorrichtung zur differentiellen Verarbeitung, die direkt durch Schließung des Schaltelements gesteuert wird, die Versorgung des zweiten Eingangs sicherstellt.

2. Messschaltung nach Anspruch 1, **dadurch gekennzeichnet, dass** die elektrische Messgröße der Kontaktscheinwiderstand des Schaltelements (CC) ist, der über die Potentialdifferenz zwischen dem stromaufwärtigen und dem stromabwärtigen Potential erhalten wird.

3. Messschaltung nach einem der Ansprüche 1 oder 2, **dadurch gekennzeichnet, dass** das Schaltelement bei seinem Schließen als Shunt wirkt, der für das Messen der elektrischen Größe verwendet wird.

4.  Messschaltung nach einem der Ansprüche 1 bis 3, **dadurch gekennzeichnet, dass** das Schaltelement ein bistabiler Schalter ist.

5.  Messschaltung nach einem der Ansprüche 1 bis 4, **dadurch gekennzeichnet, dass** die Schutzvorrichtung für das stromaufwärtige Potential (BF1) Schutzmittel zum Schutz des ersten Eingangs der Vorrichtung zur differentiellen Verarbeitung (BF4) vor der Polumkehr aufgrund der Umschaltung des Schaltelements aufweist.

6.  Messschaltung nach Anspruch 5, **dadurch gekennzeichnet, dass** die Schutzvorrichtung für das stromaufwärtige Potential (BF1) ferner zwei Transistoren (M1, M2) aufweist, die gegensinnig angeordnet sind und eine unidirektionale Polarisierungsrichtung vorgeben.

7.  Messschaltung nach Anspruch 6, **dadurch gekennzeichnet, dass** die Schutzvorrichtung für das stromaufwärtige Potential (BF1) ferner zwei Widerstände (R1, R2) aufweist, welche die beiden Transistoren (M1, M2) gleichzeitig polarisieren.

8.  Messschaltung nach Anspruch 6 oder 7, **dadurch gekennzeichnet, dass** die Schaltvorrichtung (BF2) für das stromaufwärtige Potential einen Transistor (M3) aufweist, der die beiden Transistoren (M1, M2) umschaltet, wenn das Schaltelement in die Schließstellung gesteuert wird.

9.  Messschaltung nach Anspruch 8, **dadurch gekennzeichnet, dass** die Schaltvorrichtung (BF2) für das stromaufwärtige Potential (BF1) ferner einen Vorspannungsschaltkreis aufweist, der dimensioniert ist, um die Schutzvorrichtung (BF1) für das stromaufwärtige Potential im gesamten Betriebsbereich einer Batterie zu polarisieren.

10. Messschaltung nach einem der Ansprüche 1 bis 9, **dadurch gekennzeichnet, dass** die Schutzschaltung (BF3) für das stromabwärtige Potential identisch mit der Schutzschaltung (BF1) für das stromaufwärtige Potential ausgewählt ist.

11. Messschaltung nach einem der vorangehenden Ansprüche, **dadurch gekennzeichnet, dass** die Vorrichtung zur differentiellen Verarbeitung (BF4) einen Operationsverstärker (AO) als Subtrahierer geschaltet aufweist.

12. Messschaltung nach Anspruch 11, **dadurch gekennzeichnet, dass** die Subtrahiererschaltung umfängliche Widerstände aufweist, die so ausgewählt sind, dass das Verhältnis der Widerstände (R9/R10), die an den ersten Eingang (E+) des Operationsverstärkers angeschlossenen sind, gleich dem Verhältnis der Widerstände (R7/R8) ist, die an den zweiten Eingang (E-) des Operationsverstärkers angeschlossen sind.

13. Messschaltung nach den Ansprüchen 5 und 12, **dadurch gekennzeichnet, dass** die Transistoren (M1, M2) mit geringen internen Widerstandswerten gegenüber dem Widerstand (R9) des Eingangs (E+) der Subtrahiererschaltung gewählt sind.

14. Messschaltung nach einem der vorangehenden Ansprüche, **dadurch gekennzeichnet, dass** die Versorgungsvorrichtung (BF5) eine Diode aufweist, welche die Vorrichtung zur differentiellen Verarbeitung (BF4) vor Polumkehrungen schützt.

15. System zur Funktionsdiagnose eines Schaltelements mit einer Messschaltung nach einem der vorangehenden Ansprüche, **dadurch gekennzeichnet, dass** es ferner eine Verarbeitungseinheit (UdT) aufweist, um Abweichungen der elektrischen Messgröße zu überwachen.

**Claims**

1.  Measurement circuit of an electrical magnitude at the terminals of a switching element (CC) having a first terminal at an upstream potential (VA) and a second terminal at a downstream potential (VB), the measurement circuit comprising a device for differential processing (BF4) of the upstream and downstream potentials supplied by a supply device (BF5), **characterised by** the fact that the supply device operates only on the closure of the switching element, a protection device (BF1) of the upstream potential between the said first terminal and a first input of the differential processing device controlled by a switching device (BF2) of the upstream potential providing the supply of the said first input only when the switching element is closed and a downstream protection device (BF3) between the said second terminal and a second input of the differential processing device controlled directly by the closure of the switching element providing the supply of the said second input.

2.  Measurement circuit as described in claim 1, **characterised by** the fact that the electrical magnitude measured is the contact impedance of the switching element (CC) obtained by means of the potential difference between the upstream and downstream potentials.

3.  Measurement circuit as described in claim 1 or 2, **characterised by** the fact that the switching element acts on its closure as a shunt used for the measurement of the electrical magnitude.

4.  Measurement circuit as described in one of claims 1 to 3, **characterised by** the fact that the switching element is a bistable switch.

5.  Measurement circuit as described in one of claims 1 to 4, **characterised by** the fact that the protection device of the upstream potential (BF1) comprises means for protection of the first input of the differential processing device (BF4) against bias inversion due to the switching of the switching element.

6.  Measurement circuit as described in claim 5, **characterised by** the fact that the device for protection of the upstream potential (BF1) comprises two transistors (M1, M2) mounted head to tail imposing a unidirectional bias direction.

7.  Measurement circuit as described in claim 6, **characterised by** the fact that the device for protection of the upstream potential (BF1) comprises in addition two resistances (R1, R2) biasing the two transistors (M1, M2) simultaneously.

8.  Measurement circuit as described in claim 6 or 7, **characterised by** the fact that the switching device (BF2) of the upstream potential comprises a transistor (M3) switching the two transistors (M1, M2) when the switching element is commanded to close.

9.  Measurement circuit as described in claim 8, **characterised by** the fact that the switching device (BF2) of the upstream potential comprises in addition a biasing circuit dimensioned to bias the protection device (BF1) of the upstream potential within the whole operating range of a battery.

10. Measurement circuit as described in one of claims 1 to 9, **characterised by** the fact that the protection circuit (BF3) of the downstream potential is selected identical to the protection circuit (BF1) of the upstream potential.

11. Measurement circuit as described in one of the preceding claims, **characterised by** the fact that the differential processing device (BF4) comprises an operational amplifier (AO) in a subtraction circuit.

12. Measurement circuit as described in claim 11, **characterised by** the fact that the subtraction circuit comprises peripheral resistances so selected that the ratio of the resistances (R9/R10) connected to the first input (E+) of the operational amplifier is equal to the ratio of the resistances (R7/R8) connected to the second input (E-) of the operational amplifier.

13. Measurement circuit as described in claims 5 and 12, **characterised by** the fact that the transistors (M1, M2) are selected with low internal resistance values relative to the input (E+) resistance (R9) of the subtraction circuit.

14. Measurement circuit as described in one of the preceding claims, **characterised by** the fact that the supply device (BF5) comprises a diode protecting the differential processing device (BF4) against bias inversions.

15. Functional diagnostic system of a switching element comprising a measurement circuit as described in any one of the preceding claims, **characterised by** the fact that it comprises in addition a processing unit (UdT) to monitor the drifts of the measured electrical magnitude.

BAT

VA

VB

Commutateur monostable — Charge 1

Commutateur bistable — Charge 2

Charge 3

Commutateur statique — Charge

Acquisition des signaux → Protection et filtrage des entrées → Traitement différentiel → Amplification Mise en forme → Unité de traitement

**Figure 1**

EP 2 494 564 B1

**Figure 2**

**Figure 5**

**Figure 3**

**Figure 4**

**EP 2 494 564 B1**

## RÉFÉRENCES CITÉES DANS LA DESCRIPTION

**Documents brevets cités dans la description**

- EP 1462768 A2